# EUROPEAN PATENT SPECIFICATION

(11) **EP 0 371 512 B1**
(45) Date of publication and mention of the grant of the patent: **23.03.1994**
(21) Application number: 89122196.2
(22) Date of filing: 01.12.1989
(51) Int. Cl.: H05K 3/40, H01B 1/02, H01B 1/08

(54) **Conducting material and method of fabrication thereof**
Leitfähiges Material und Verfahren zu seiner Herstellung
Matériau conducteur et son procédé de fabrication

(30) Priority: 01.12.1988 JP 306582/88
(43) Date of publication of application: 06.06.1990
(73) Proprietor: FUJITSU LIMITED, Kawasaki-shi, Kanagawa 211 (JP)
(72) Inventor: Abe, Konichiro Fujitsu Ltd. Pat. Dep., Nakahara-ku Kawasaki-shi Kanagawa 211 (JP)
(74) Representative: Greenstreet, Cyril Henry

(56) References cited:
- EP-A- 0 059 348
- EP-A- 0 272 129
- US-A- 4 594 181
- PATENT ABSTRACTS OF JAPAN,vol. 007, no. 167 (C-177) 22 July 1985 & JP-A-58-074759
- PATENT ABSTRACTS OF JAPAN,vol. 013, no. 421 (E-822) 19 September 1989 & JP-A-01-157592

## Description

The present invention relates to a conducting material and its use for forming a via in a ceramic sheet.

To improve the packing density of semiconductor elements in electronic devices, a multilayer ceramic substrate made from a stack of green sheets has been widely used as a printed wiring substrate.

Such a multilayer ceramic substrate is generally formed by stacking green sheets having through holes filled with conducting material and then firing such green sheets. Wiring patterns formed between stacked sheets are electrically connected through the vias formed in the through holes. To form the vias, copper has been used as a conducting material in order to obtain a low electrical resistance.

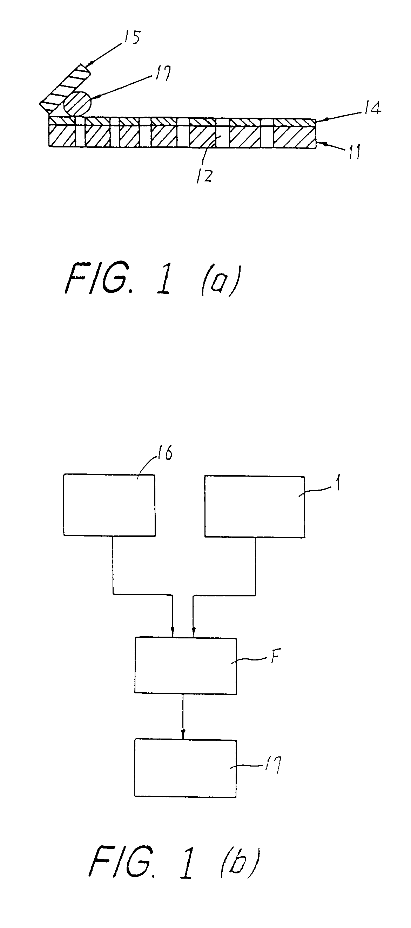

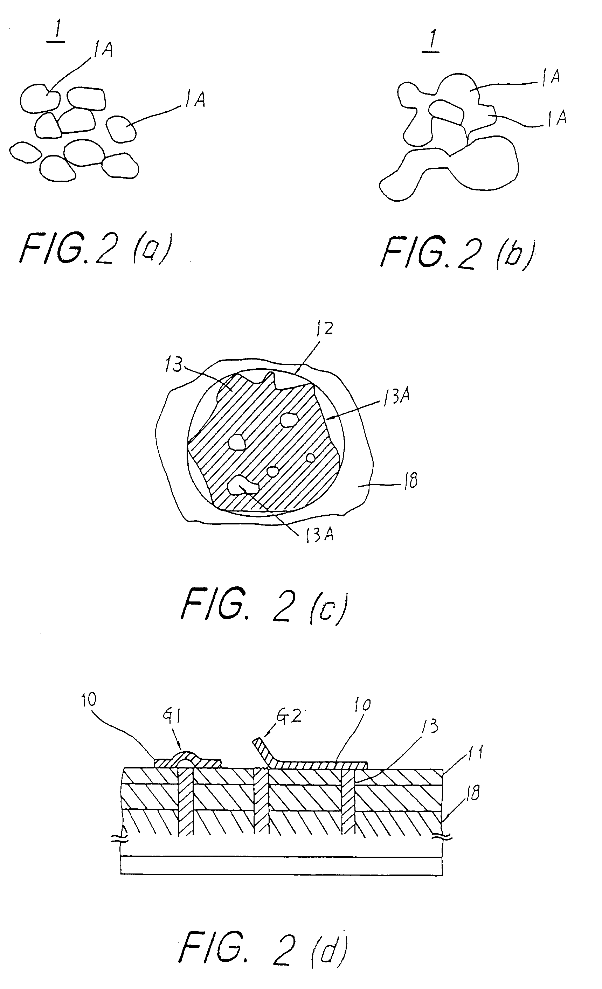

The conventional via forming method will be explained with reference to Figs. 1 and 2 of the drawings. Fig 1(a) is a schematic sectional view showing the via forming method. A green sheet 11 is provided with a plurality of through holes 12 at predetermined positions. A mask 14 is stacked on this green sheet 11 and the surface of the mask 14 is then coated with copper paste 17 by a squeegee 15. In this process, the through holes 12 are filled with copper paste 17.

The method of making the copper paste 17 is shown in Fig. 1(b). First, copper powder 1, having a grain size of about 1 µm, and a solvent 16 such as MEK (methyl ethyl ketone) are mixed and kneaded in a mixing process F by a mixer.

A method for fabricating a ceramic circuit substrate using such copper paste has been disclosed, for example, in the Japanese laid-open patent application 63-271995 (laid-open date: 28th September 1988) by H. Yokoyama, M. Tsukada and H. Suzuki.

As shown in Fig. 2(a), in the copper paste 17 filling the through holes 12 there is clearance between particles 1A of copper powder 1. When the green sheet 11 is fired at a temperature of about 800°C, the copper paste is sintered and particles 1A bind with each other as shown in Fig. 2(b). As a result, the copper paste 17 filling the through holes 12 forms vias 13 as shown schematically in section, parallel to the green sheet surface, in Fig. 2(c).

The copper paste 17 used to form the vias 13 by sintering includes many organic materials, which are vaporised during the sintering process. If such vaporisation occurs during the firing of the green sheet 11, pores 13A are formed, as shown in Fig. 2(c), at the boundary of the internal surface of the through hole 12 and the via 13 and within the via 13, and the binding between particles 1A becomes non-dense, resulting in the problem that the electrical resistance of the via 13 is increased.

Another problem that also arises is illustrated by Fig. 2(d), which is a schematic sectional view of a multilayer ceramic substrate 18 fabricated by sintering a plurality of stacked green sheets 11.

When expansion of vapour of organic materials during the firing process occurs, this generates a mound G1 in the pattern 10 formed on the surface of green sheet 11 at the position of the via 13, and peeling G2 of a pattern is also caused. As a result, the vias 13 are no longer accurately connected to the pattern 10.

An embodiment of the present invention provides a conducting material suitable for making vias during the sintering of green sheet which comprises a mixture of spheroidised copper powder particles and spheroidised copper oxide powder particles, the surface of the individual copper and copper oxide particles being coated with an organic titanium film.

Another embodiment of the invention provides a process of producing such a material which comprises kneading a mixture of copper powder and a predetermined amount of copper oxide powder with a solvent including organic titanium; drying the mixed powder to form solidified particles coated by a film of organic titanium; cracking the solidified particles to respective particles of copper powder and copper oxide powder; classifying the cracked particles according to grain size and then spheroidising the particles, for example by the high-speed gas flow collision method.

The copper oxide powder added in the predetermined amount to copper powder is reduced in the sintering process, and active oxygen is generated at this time. Vaporisation of organic materials is accelerated by the effect of such active oxygen, so that vaporisation can be carried out at a lower temperature than is required if copper oxide powder is not included. Accordingly, generation of pores in the region between the internal surface of the through holes and the via and within the via can be suppressed.

Moreover, since the respective particles of copper powder and copper oxide powder are coated with an organic titanium film, the adhesion of the respective particles to the internal surface of the through hole can be improved.

In addition, the packing density of the mixed powder of copper powder and copper oxide powder in the through hole can also be increased by spheroidising the respective particles of copper powder and copper oxide powder.

As a result, vias having lower electrical resistance and ensuring accurate connection with the pattern can be fabricated by filling the through holes of green sheet with the conducting material and employing the via fabrication method of the present invention.

Further embodiments of the invention provide multilayer ceramic substrates for semiconductor elements packed at high density, said multilayer ceramic substrate comprising:
a plurality of ceramic substrates formed by firing stacked green sheets having through holes therein;
circuit patterns provided on said ceramic substrates; and
a plurality of vias in said through holes, for connecting said circuit patterns, formed by firing, in said holes, conducting material according to the invention or made by the process of the invention.

Preferred embodiments of the invention will now be described, by way of example, with reference to the accompanying drawings, in which Figs. 3 to 6 relate specifically to the present invention. In the drawings,
Fig. 1(a) is a schematic sectional view indicating a method of coating with copper paste in the fabrication of vias;
Fig. 1(b) is a block diagram indicating the process of conventional copper paste fabrication;
Fig. 2(a) is a schematic diagram indicating the condition of copper particles of conventional copper paste;
Fig. 2(b) is a schematic diagram indicating the condition of copper particles after the copper paste of Fig. 2(a) has been sintered at 800°C;
Fig. 2(c) is a schematic sectional view through a via parallel to a conventional green sheet;
Fig. 2(d) is a schematic sectional view including vias in a conventional multilayer ceramic substrate;
Fig. 3(a) is a schematic sectional view indicating a method of loading the mixed powder into through holes of a green sheet according to the present invention;
Fig. 3(b) is a block diagram showing the conducting material fabrication process of the present invention;
Fig. 4(a) is a schematic diagram showing copper and copper oxide particles in the mixed powder of copper and copper oxide powder;
Fig. 4(b) is a schematic diagram showing copper powder particles and copper oxide powder particles coated with an organic titanium film;
Fig. 4(c) is a schematic diagram showing spherical copper and copper oxide particles coated with an organic titanium film and having a grain size less than a predetermined value;
Fig. 4(d) is a schematic diagram showing a through hole in a green sheet filled with the conducting material fabricated by the process of Fig. 3(b);
Fig. 4(e) is a schematic showing a via formed by sintering the conducting material filling the through holes of a multilayer ceramic substrate;
Fig. 5(a) is a scanning electronic micrograph of a part of column surface of a via formed when copper powder without added copper oxide powder is used on conducting material;
Figs. 5(b) to 5(f) are similar scanning electron micrographs of the column surface of five vias made from copper powder to which, respectively, 1%, 5%, 10%, 25% and 50% of copper oxide had been added.
Fig. 6(a) is a schematic sectional view through a through hole before firing, filled with a mixed powder which has been formed by the conducting material fabrication process of the present invention shown in Fig. 3(b), from which only the spheroidising step has been omitted;
Fig. 6(b) is a similar schematic sectional view through a through hole, before firing, filled with a mixed powder which has been formed by the conducting material fabrication process of the present invention shown in Fig. 3(b);
Fig. 6(c) is a scanning electron micrograph of a section parallel to the green sheet surface of a via fabricated corresponding to Fig. 6(a); and
Fig. 6(d) is a scanning electron micrograph of a section parallel to the green sheet surface of a via fabricated corresponding to Fig. 6(b).

Like elements are designated by like reference numerals throughout the drawings.

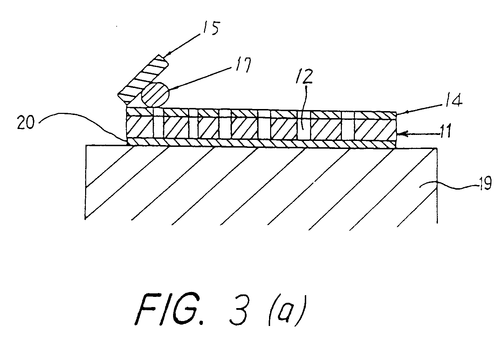

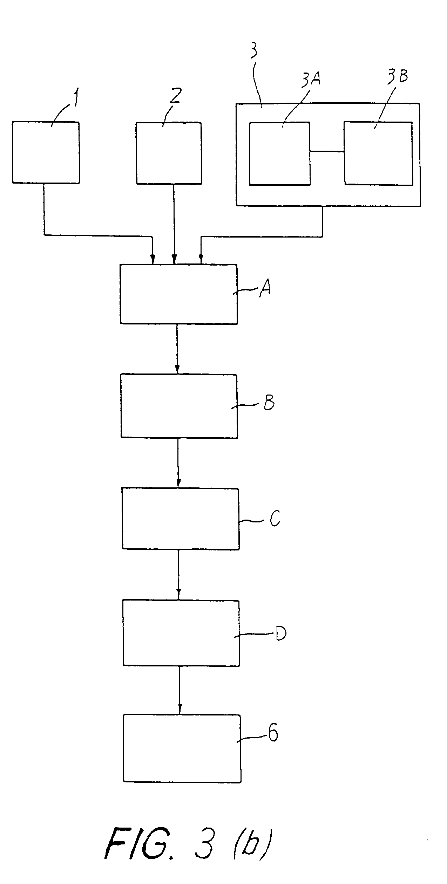

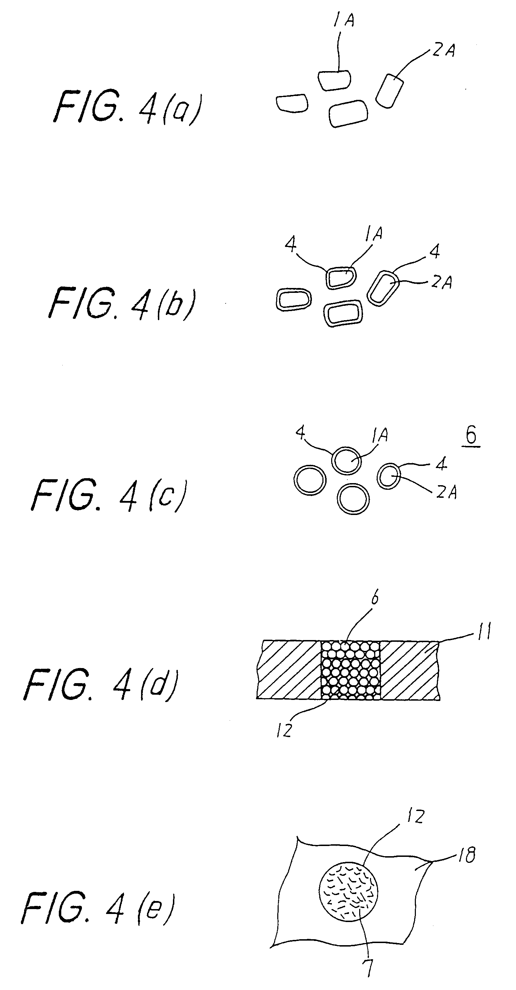

Referring to Figs. 3 to 6, Fig. 3(b) is a block diagram showing a conducting material fabrication process of the present invention and Fig. 4 is a diagram indicating the conditions of powder particles at each stage of the process.

First, from 1 to 20% of copper oxide powder 2 is mixed with the copper powder 1, with a grain size of about 1 µm. This condition is indicated in Fig. 4(a) as the copper powder particles 1A and copper oxide powder particles 2A.

Meanwhile, as shown in Fig. 3(b), a solution 3 is obtained by dissolving an organic titanium 3B (for example, isosulfonyltridecylbenzene titanate) in MEK (3A) in the proportion of 0.5% by weight of the mixed powder of copper powder 1 and copper oxide powder 2.

Next, the copper powder 1 and copper oxide powder 2 are mixed with the solution 3 for about 30 minutes in the mixing process A. After mixing by the mixing process A, MEK 3A included in the solution 3 is vaporised and dried in the drying process B of Fig. 3(b). Thereby, the surface of copper powder particles 1A and copper oxide powder particles 2A are coated with an organic titanium film 4 as shown in Fig. 4(b).

Thereafter, the mixed powder solidified by the drying process B is cracked and is classified through a sieve of about 100 mesh in the classifying process C of Fig. 3(b). As a result, the grain size of copper powder particles 1A and copper oxide powder particles 2A is all kept at a value less than a predetermined value. As described above, the mixed powder having a grain size less than the predetermined value is spheroidised in the spheroidising process D of Fig. 3(b) by the high-speed gas flow collision method, for example using the hybridisation system (Nara Machinery Works, Co.). The high-speed gas collision method flow is described in detail, for example, in "Fine Particle Design", page 157, by Masazumi Koishi, published by the Industrial Survey Institute.

As a result, the conducting material 6 comprising a mixed powder consisting of spheroidised powder particles coated with organic titanium film having a grain size less than the predetermined value can be formed, as shown in Fig. 4(c).

The conducting material 6 fabricated by the processes of Fig. 3(b) is used to fill the through holes 12 of green sheet 11 as shown in Fig. 4(d) using a mask 14 as in the prior art method of Fig. 1(a). However, in the present invention, since the particles 1A and 2A are spheroidised, the packing density in the through hole is sufficiently large.

Further, in order to obtain better filling for all the through holes of the green sheet 11, a porous tetrafluoroethylene resin sheet 20 is interposed between the green sheet 11 and a suction table 19 on which the green sheet 11 is placed, as shown in Fig. 3(a) (a suction pump is not depicted) and the conducting material is drawn into the through holes by suction. Interposing the porous tetrafluoroethylene resin sheet 20 makes the sucking force uniform over all the through holes of the green sheet 11. As a result, loading the conducting material 6 into all the through holes can be performed uniformly. As described above, a multilayer ceramic substrate 18, in which the vias 13 are formed by sintering the conducting material 6 filling the through holes 12 as shown in Fig. 4(e), may be fabricated by firing the green sheet 11 in which the through holes thereof are filled with the conducting material 6.

The firing of the green sheet is generally carried out at a temperature of about 800°C. During such firing, organic materials included in the conventional conducting material (copper paste) start to be decomposed at about 400°C. Some of them are vapourised, while others remain. Those remaining as carbon are vapourised at 600 to 800°C. However, when copper oxide powder 2 is mixed with the conducting material as in the case of the present invention, decomposition of residual carbon is accelerated and it is vapourised at 600°C as oxides. Therefore, no carbon remains to be vapourised by firing at 800°C.

The organic titanate film coating the surface of the copper powder particles 1A and copper oxide powder particles 2A is changed to titanium oxide (TiO₂) in the process of firing the green sheet at 800°C. As a result, the conducting material 6 of the present invention is used for filling the through holes 12 of green sheet 11 and is sintered. In this case, the titanium oxide easily binds with alumina included in the green sheet 11 and thereby the vias 7 adhere to the internal surface of the through hole 12.

As explained above, in the present invention, the packing density of particles 1A and 2A in the via 7 is high, pores are not generated at the interface between the interior of via 7, and the internal surface of the through hole 12, and thereby the electrical resistance of the via, can be minimised.

In the embodiment explained above, the weight ratio of copper oxide powder 2 to the copper powder 1 is selected to be from 1 to 20%: it has been shown by experiments of the inventor that such range of weight ratio is the best range of weight ratio.

Vias have been fabricated using five kinds of mixed powder, with respective properties of 1%, 5%, 10%, 25% and 50% of copper oxide powder 2 to copper powder 1, and the respective metallic structures have also been compared using a scanning electron microscope (SEM).

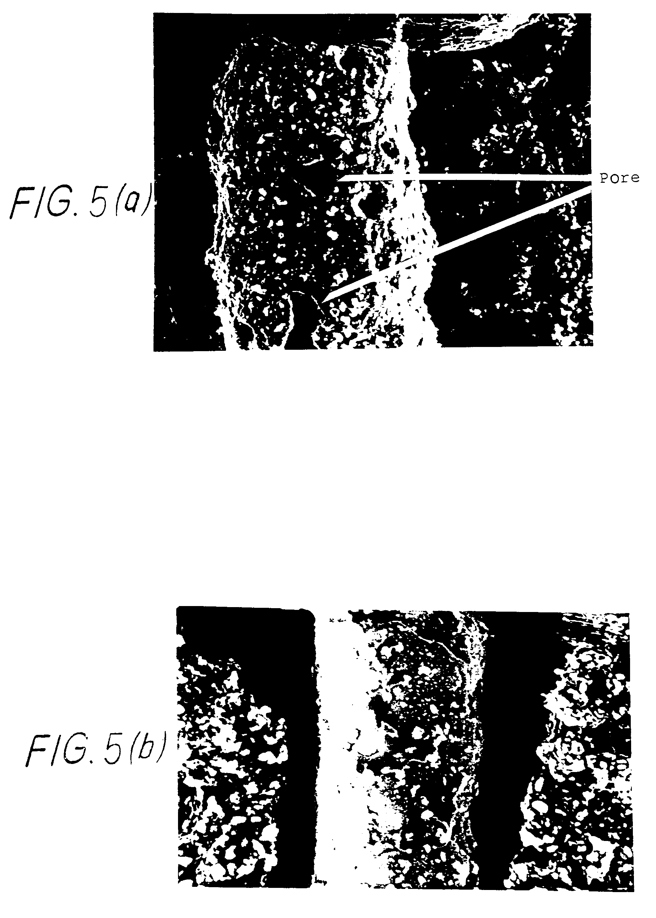

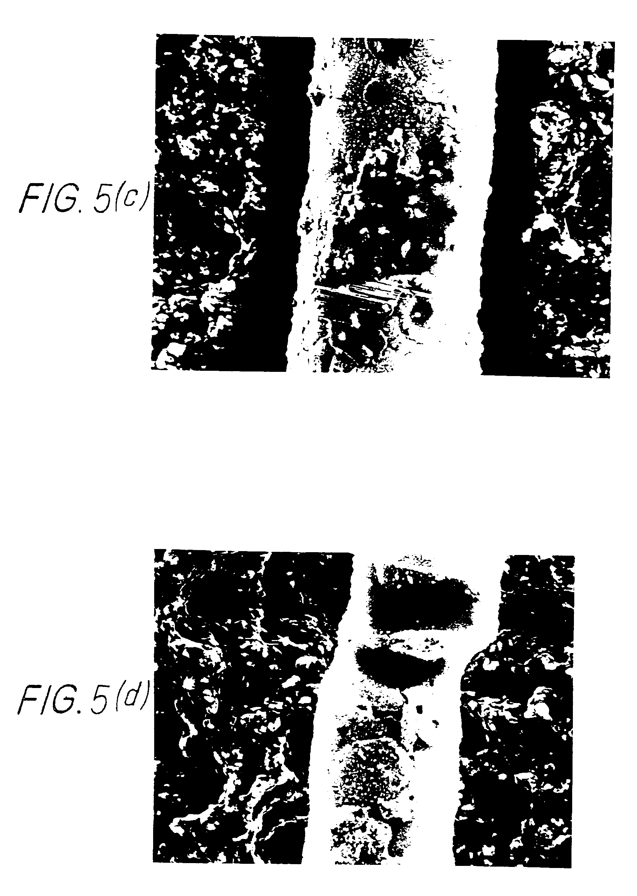

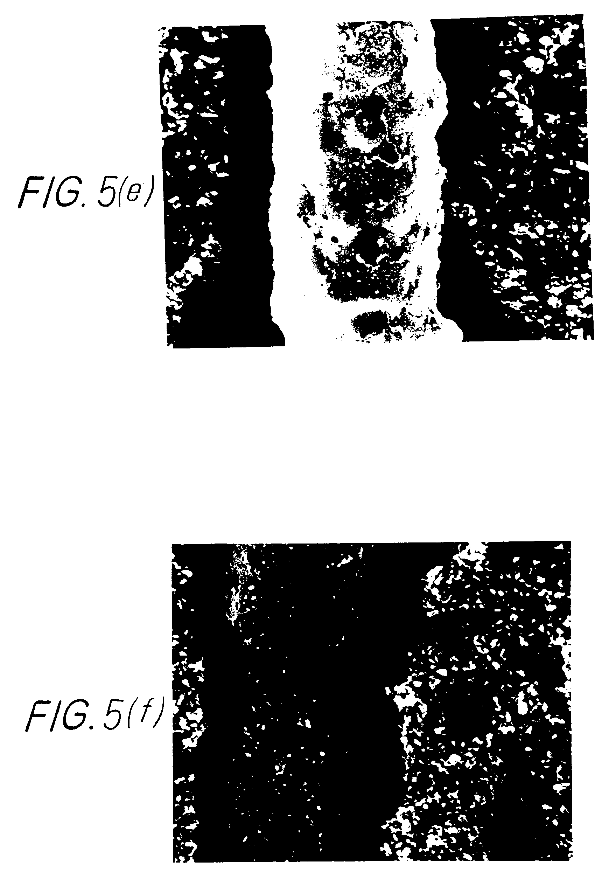

Figs. 5(a) to 5(f) show scanning electron micrographs of a part of the cylindrical surface of an exposed via in which the ceramic at the side surface of multilayer ceramic substrate 18 is selectively etched so that the via 7 is exposed. The magnification factor of these photomicrographs is x 1000.

Fig. 5(a) is an example of a conventional via 13 made from copper powder to which copper oxide powder 2 is not added. The white column passing vertically through the central area is the via 13, and many pores, indicated by the arrow marks, can be observed in this column.

Fig. 5(b) is a scanning electron micrograph of a via 7 in which 1% of copper oxide powder 2 is added to copper powder. The white column passing vertically through the central area is the via 7 as shown in Fig. 5(a). Some black pores 13A exist in the via 7, but the number of such pores is very small.

Fig. 5(c), Fig. 5(d) and Fig. 5(e) respectively show the corresponding scanning electron micrographs in the case that 5%, 10% and 25% respectively of copper oxide powder 2 is added. The white column passing vertically through the central area is also via 7 as in the case of Fig. 5(a) and Fig. 4(b). Hardly any black pores 13 are present in the vias shown in Figs. 5(c), 5(d) and 5(e).

Fig. 5(f) shows a photomicrograph in which 50% of the copper oxide powder 2 is added. In this case, pore 13A does not exist in the via 7 as in the case of Fig. 5(c), Fig. 5(d) and Fig. 5(e). However, in this case, the proportion of copper oxide to copper is large and therefore reduction of copper oxide does not proceed sufficiently, and it remains unchanged. Accordingly, sintering of mixed powder of copper powder 1 and copper oxide powder 2 is interfered with and the shape of the sintered copper becomes irregular, resulting in easy disconnection of the copper. In Fig. 5(f), a part of a copper grain having an anomalously large grain size is shown. Therefore, it is desirable that amount of copper powder to be added is selected to be 50% or less.

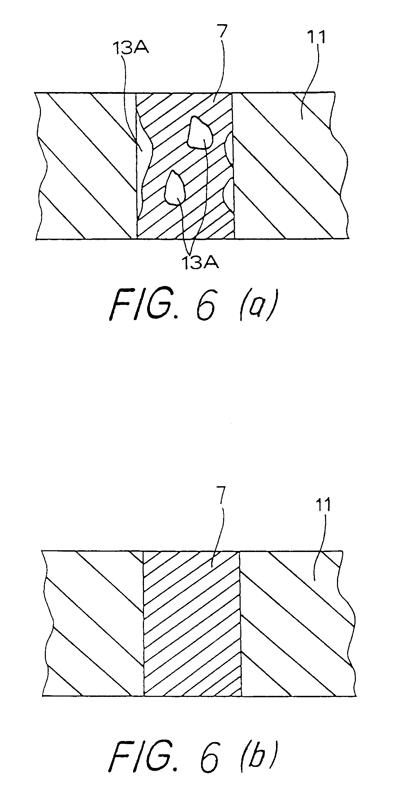

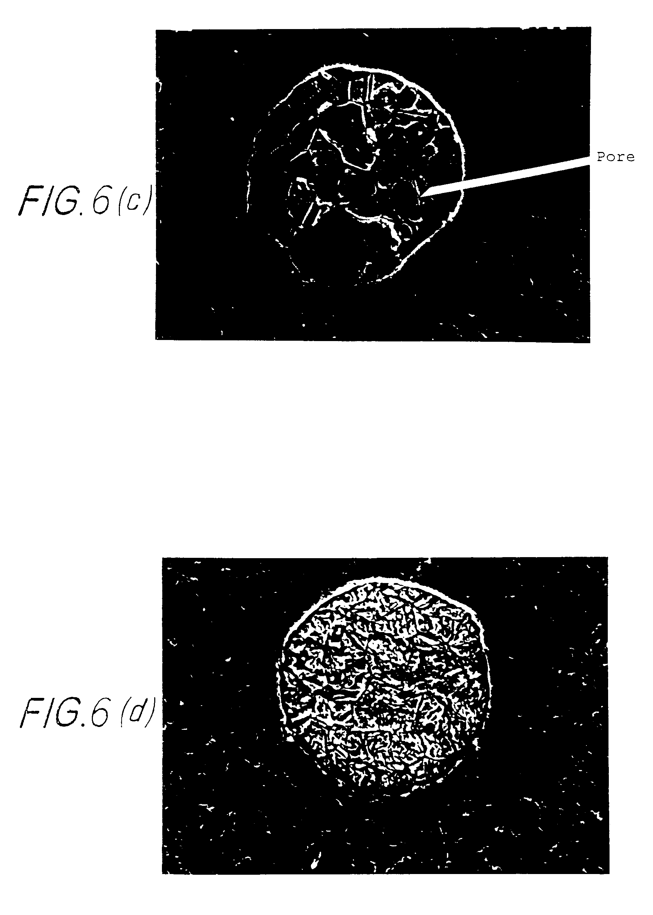

Next, the effect of the process of spheroidising the mixed powder of copper powder 1 and copper oxide powder 2 in the present invention will be explained with reference to Figs. 6(a) to 6(d).

Fig. 6(a) is a schematic sectional diagram showing a through hole 12 filled, before firing, with a mixed powder fabricated by the conducting material fabrication process of the present invention shown in Fig. 3(b), but omitting only the spheroidising step. It is shown that some pores exist in the mixed powder filling the through holes 12 and the area between the mixed powder and internal walls of the through hole 12.

Fig. 6(b) is a schematic sectional diagram showing a through hole 12 filled, before firing, with a mixed powder fabricated by the conducting material fabrication process of the present invention shown in Fig. 3(b), including the spheroidisation step. As shown in Fig. 6(b) when, unlike Fig. 6(a), the through hole 12 is filled with the conducting material fabricated by the present invention, the mixed powder is almost uniformly packed without generation of pores, because each particle of mixed powder is spheroidised.

Fig. 6(c) and Fig. 6(d) respectively show scanning electron micrographs of a section parallel to the green sheet surface of the via 7 formed by firing the filled green sheets shown in Figs. 6(a) and 6(b). Copper is selectively etched so that the state of the via 7 formed in the through hole 12 becomes apparent. The magnification factor of the respective micrographs is set to x 1000.

Fig. 6(c) is scanning electron micrograph of via 7 formed without the spheroidising process, corresponding to Fig. 6(a). The packing density in circular through hole 12 is bad and pores 13A as indicated by the arrow mark are generated between the internal wall surface of the through hole 12 and the via 7.

Fig. 6(d) is a scanning electron micrograph of via 7 fabricated from spheroidised powder, corresponding to Fig. 6(b). In this case, packing density in the circular through hole 12 is good and no pores 13A are formed between the internal wall surface of the through hole 12 and the via 7 or in the via 7 itself.

For fabrication of the via 7 shown in Figs. 6(a) and 6(b), a material having the composition: copper powder 90 g, copper oxide powder 10 g, organic titanium is 0.5 g and MEK 200 ml was used.

## Claims

1. A conducting material comprising a mixture of spheroidised copper powder particles and spheroidised copper oxide powder particles, the surface of the individual copper and copper oxide particles being coated with an organic titanium film.

2. A conducting material according to claim 1 wherein the proportion of said copper oxide powder particles in the mixture is within the range between 1% and 50% of the weight of said copper powder particles.

3. A conducting material according to claim 1 or claim 2 wherein said organic titanium is isosulfonyltridecylbenzene titanate.

4. A method of producing a conducting material according to claim 1, comprising the steps of:
kneading a mixture of copper powder particles and copper oxide powder particles with a solvent containing organic titanium;
drying and solidifying said mixed powder particles to produce solidified mixed powder particles;
cracking said solidified mixed powder particles to produce cracked mixed powder particles;
classifying said cracked mixed powder particles to produce classified mixed powder particles of predetermined grain size; and
spheroidising said classified mixed powder particles.

5. A method according to claim 4 wherein the weight of said copper oxide powder particles in the mixture is within the range between 1% and 50% of the weight of said copper powder particles.

6. A method according to claim 4 or claim 5 wherein said solvent is methyl ethyl ketone and contains said organic titanium is an amount of about 0.5% by weight of the copper and copper oxide powder particles dissolved therein.

7. A method according to any one of claims 4 to 6 wherein said organic titanium is isosulfonyltridecylbenzene titanate.

8. A method according to any one of claims 4 to 7 wherein said step of classifying said cracked mixed powder particles is carried out using a 100-mesh sieve.

9. A method according to any one of claims 4 to 8 wherein said step of spheroidising said classified mixed powder particles is carried out by a high-speed gas flow collision method.

10. The use of a conductive material according to any one of claims 1 to 3 or made according to any one of claims 4 to 9 to fill through holes in green sheets and form vias therein on firing the green sheets.

11. A method of fabricating vias in through holes of a green sheet which comprises filling the through holes with spheroidised classified mixed powder particles made by the process of any one of claims 4 to 9 by sucking said particles into the through holes, the suction being applied through a porous sheet placed behind the through holes when viewed in the direction of suction.

12. A method according to claim 11 wherein said porous sheet is made of tetrafluoroethylene resin.

13. A multilayer ceramic substrate for semiconductor elements packed at high density, said multilayer ceramic substrate comprising:
a plurality of ceramic substrates formed by firing stacked green sheets having through holes therein;
circuit patterns provided on said ceramic substrates; and
a plurality of vias in said through holes, for connecting said circuit patterns, formed by firing, in said holes, conducting material according to any one of claims 1 to 3 or made according to any one of claims 4 to 9.

## Patentansprüche

1. Ein Leitermaterial mit einer Mischung aus kugelförmigen Kupferpulverpartikeln und kugelförmigen Kupferoxidpulverpartikeln, wobei die Oberfläche der individuellen Kupfer- und Kupferoxidpartikel mit einem organischen Titanfilm überzogen ist.

2. Ein Leitermaterial nach Anspruch 1, bei dem der Anteil der genannten Kupferoxidpulverpartikel in der Mischung innerhalb des Bereiches zwischen 1% und 50% des Gewichtes der genannten Kupferpulverpartikel liegt.

3. Ein Leitermaterial nach Anspruch 1 oder Anspruch 2, bei dem das genannte organische Titan Isosulfonyltridecylbenzoltitanat ist.

4. Ein Verfahren zum Herstellen eines Leitermaterials nach Anspruch 1, mit den Schritten:
Verkneten einer Mischung aus Kupferpulverpartikeln und Kupferoxidpulverpartikeln mit einem Lösungsmittel, das organisches Titan enthält;
Trocknen und Verfestigen der genannten vermischten Pulverpartikel, um verfestigte vermischte Pulverpartikel herzustellen;
Spalten der genannten verfestigten vermischten Pulverpartikel, um gespaltene vermischte Pulverpartikel herzustellen;
Klassieren der genannten gespaltenen vermischten Pulverpartikel, um klassierte vermischte Pulverpartikel mit vorbestimmter Korngröße herzustellen; und
Kugelformen der genannten klassierten vermischten Pulverpartikel.

5. Ein Verfahren nach Anspruch 4, bei dem das Gewicht der genannten Kupferoxidpulverpartikel in der Mischung innerhalb des Bereiches zwischen 1% und 50% des Gewichtes der genannten Kupferpulverpartikel liegt.

6. Ein Verfahren nach Anspruch 4 oder Anspruch 5, bei dem das genannte Lösungsmittel Methylethylketon ist und das genannte organische Titan in einer Menge von etwa 0,5 Gewichts-% der Kupfer- und Kupferoxidpulverpartikel enthält, die darin gelöst sind.

7. Ein Verfahren nach einem der Ansprüche 4 bis 6, bei dem das genannte organische Titan Isosulfonyltridecylbenzoltitanat ist.

8. Ein Verfahren nach einem der Ansprüche 4 bis 7, bei dem der genannte Schritt des Klassierens der genannten gespaltenen vermischten Pulverpartikel unter Verwendung eines Siebs mit einer 100er Körnung ausgeführt wird.

9. Ein Verfahren nach einem der Ansprüche 4 bis 8, bei dem der genannte Schritt des Kugelformens der genannten klassierten vermischten Pulverpartikel durch ein Hochgeschwindigkeitsgasströmungskollisionsverfahren ausgeführt wird.

10. Die Verwendung eines Leitermaterials nach einem der Ansprüche 1 bis 3, oder das nach einem der Ansprüche 4 bis 9 hergestellt wurde, um Durchgangslöcher in rohen Blättern zu füllen und darin beim Brennen der rohen Blätter Durchkontakte zu bilden.

11. Ein Verfahren zum Herstellen von Durchkontakten in Durchgangslöchern eines rohen Blattes, das das Füllen der Durchgangslöcher mit kugelförmigem klassierten vermischten Pulverpartikeln umfaßt, die durch das Verfahren nach einem der Ansprüche 4 bis 9 hergestellt wurden, durch Saugen der genannten Partikel in die Durchgangslöcher, wobei das Saugen durch ein poröses Blatt angewendet wird, das in Saugrichtung gesehen hinter den Durchgangslöchern angeordnet ist.

12. Ein Verfahren nach Anspruch 11, bei dem das genannte poröse Blatt aus Tetrafluorethylenharz besteht.

13. Ein Mehrlagenkeramiksubstrat für Halbleiterelemente, die mit hoher Dichte gepackt sind, welches Mehrlagenkeramiksubstrat umfaßt:
eine Vielzahl von Keramiksubstraten, die durch Brennen von gestapelten rohen Blättern mit Durchgangslöchern darin gebildet sind;
Schaltungsmuster, die auf den genannten Keramiksubstraten vorgesehen sind; und
eine Vielzahl von Durchkontakten in den genannten Durchgangslöchern, zum Verbinden der genannten Schaltungsmuster, die in den genannten Löchern durch Brennen von Leitermaterial nach einem der Ansprüche 1 bis 3, oder das nach einem der Ansprüche 4 bis 9 hergestellt wurde, gebildet sind.

## Revendications

1. Matériau conducteur comprenant un mélange de particules de poudre de cuivre transformées en formes sphéroïdales et de particules de poudre d'oxyde de cuivre transformées en formes sphéroïdales, la surface des particules individuelles de cuivre et d'oxyde de cuivre étant recouverte d'un film de composé organique au titane.

2. Matériau conducteur selon la revendication 1, dans lequel la proportion desdites particules de poudre d'oxyde de cuivre dans le mélange s'inscrit dans une plage qui se situe entre 1% et 50% du poids desdites de poudre de cuivre.

3. Matériau conducteur selon la revendication 1 ou 2, dans lequel ledit composé organique au titane est du titanate d'isosulfonyltridécylbenzène.

4. Procédé de fabrication d'un matériau conducteur selon la revendication 1, comprenant les étapes de :
malaxage d'un mélange de particules de poudre de cuivre et de particules de poudre d'oxyde de cuivre avec un solvant contenant un composé organique au titane ;
séchage et solidification desdites particules de poudre mixte afin de produire des particules de poudre mixte solidifiées ;
fragmentation desdites particules de poudre mixte solidifiées pour produire des particules de poudre mixte fragmentées ;
triage desdites particules de poudre mixte fragmentées pour produire des particules de poudre mixte fragmentées présentant une dimension granulométrique prédéterminées ; et
transformation en formes sphéroïdales desdites particules de poudre mixte triées.

5. Procédé selon la revendication 4, dans lequel le poids desdites particules de poudre d'oxyde de cuivre dans le mélange s'inscrit dans une plage qui est comprise entre 1% et 50% du poids desdites particules de poudre de cuivre.

6. Procédé selon la revendication 4 ou 5, dans lequel ledit solvant est du méthyléthylcétone et il contient ledit composé organique au titane selon une quantité d'environ 0,5% en poids des particules de poudre de cuivre et de poudre d'oxyde de cuivre dissoutes dedans.

7. Procédé selon l'une quelconque des revendications 4 à 6, dans lequel ledit composé organique au titane est du titanate d'isosulfonyltridécylbenzène.

8. Procédé selon l'une quelconque des revendications 4 à 7, dans lequel ladite étape de triage desdites particules de poudre mixte fragmentées est mise en oeuvre en utilisant un tamis présentant un maillage de cent.

9. Procédé selon l'une quelconque des revendications 4 à 8, dans lequel ladite étape de transformation en formes sphéroïdales desdites particules de poudre mixte triées est mise en oeuvre au moyen d'un procédé de collision avec un écoulement gazeux haute vitesse.

10. Utilisation d'un matériau conducteur selon l'une quelconque des revendications 1 à 3 ou réalisé selon l'une quelconque des revendications 4 à 9 pour remplir les trous de passage dans les feuilles vertes et pour former des vias en leur sein lors du chauffage des feuilles vertes.

11. Procédé de fabrication de vias dans les trous de passage d'une feuille verte qui comprend le remplissage des trous de passage avec des particules de poudre mixte triées ou transformées en formes sphéroïdales, réalisées au moyen du processus selon l'une quelconque des revendications 4 à 9, en aspirant lesdites particules dans les trous de passage, l'aspiration étant effectuée au travers d'une feuille poreuse placée à l'arrière des trous de passage par rapport au sens d'aspiration.

12. Procédé selon la revendication 11, dans lequel ladite feuille poreuse est constituée par une résine tétrafluoréthylène.

13. Substrat en céramique multicouche pour des éléments semiconducteurs intégrés selon une densité élevée, ledit substrat en céramique multicouche comprenant :
une pluralité de substrats en céramique formés en chauffant des feuilles vertes empilées comportant des trous de passage en leur sein ;
des motifs de circuit produits sur lesdits substrats en céramique ; et
une pluralité de vias dans lesdits trous de passage, pour connecter lesdits motifs de circuit, formés par chauffage, dans lesdits trous, d'un matériau conducteur selon l'une quelconque des revendications 1 à 3 ou réalisés selon l'une quelconque des revendications 4 à 9.
